# EUROPEAN PATENT APPLICATION

(11) **EP 4 557 566 A1**
(43) Date of publication of application: **21.05.2025**
(21) Application number: 24210295.2
(22) Date of filing: 31.10.2024
(51) Int. Cl.: H02J 7/00

(54) **BATTERY PACK CHARGER**

(30) Priority: 03.11.2023 US 202363596057 P
(71) Applicant: Milwaukee Electric Tool Corporation, Brookfield, WI 53005 (US)
(72) Inventor: HERRO, Matthew, 53072 Wisconsin (US); VASHI, Bhaumik M, 53211 Wisconsin (US); ROSENTHAL, Jacob D, 53005 Wisconsin (US); MADER, Daniel, 53202 Wisconsin (US)
(74) Representative: Forresters IP LLP

(57) **Abstract**

A battery charger includes a housing, first and second charger interfaces, first and second vents, and a shutter. The first and second charger interfaces are formed on the housing. Each charger interface receives and charges a respective battery pack. The first and second vents are defined in the housing. Each vent provides an airflow path defined through the respective battery pack and the housing. The shutter is provided for each charger interface and can move between an actuated position, in which the shutter is oriented to at least partially block the airflow path, and an unactuated position, in which the shutter is out of the airflow path.

## Description

### CROSS-REFERENCE TO RELATED APPLICATIONS

The present application claims priority to U.S. provisional application no. 63/596,057, filed November 3, 2023, the entire contents of which are incorporated by reference herein.

### BACKGROUND

Battery chargers and the batteries coupled thereto can be prone to overheating during the charging process. Ways to address the overheating include cooling and/or modulation of the charging process.

### FIELD OF THE DISCLOSURE

The present disclosure relates to battery chargers, and more particularly to cooling a battery pack connected to a battery charger.

### SUMMARY OF THE DISCLOSURE

The present disclosure provides, in one aspect, a battery charger for charging a plurality of battery packs. The battery charger includes a housing, and first and second charger interfaces formed on the housing. Each charger interface is configured to receive and charge a respective battery pack of the plurality of battery packs. The battery charger further includes first and second vents defined in the housing and respectively provided for the first and second charger interfaces. Each vent is configured to provide an airflow path defined through the respective battery pack and the housing. Moreover, the battery charger includes a shutter provided for each charger interface. The shutter is movable between an actuated position, in which the shutter is oriented to at least partially block the airflow path, and an unactuated position, in which the shutter is out of the airflow path.

The present disclosure provides, in another aspect, a battery charger for charging a battery pack. The battery charger includes a housing and a charger interface formed on the housing. The charger interface is configured to receive and charge the battery pack. The battery charger includes a plurality of vents defined in the housing and at least one fan disposed in the housing. The fan is configured to pull air into the housing through the plurality of vents. Moreover, the battery charger includes a shutter is disposed adjacent the plurality of vents. The shutter is selectively at least partially blocking the plurality of vents.

The present disclosure provides, in another aspect, a battery charger for charging a battery pack. The battery charger includes a housing and a charger interface formed on the housing. The charger interface is configured to receive and charge the battery pack. The battery charger further includes a plurality of vents defined in the housing and configured to provide an airflow path defined through the battery pack and the housing. The battery charger also includes a shutter disposed adjacent the plurality of vents. The shutter is selectively at least partially blocking the airflow path. Moreover, the battery charger includes an actuator disposed within the housing and configured to move the shutter, and a controller disposed in the housing. The controller is configured to determine that the battery pack has made an electrical connection with the charger interface and operate the actuator to move the shutter at least partially out of the airflow path.

The present disclosure provides, in another aspect, a battery charger for charging a plurality of battery packs, the battery charger comprising:
a housing;
first and second charger interfaces formed on the housing, each charger interface configured to receive and charge a respective battery pack of the plurality of battery packs;
first and second vents defined in the housing and respectively provided for the first and second charger interfaces, each vent configured to provide an airflow path defined through the respective battery pack and the housing; and
a shutter provided for each charger interface, the shutter being movable between an actuated position, in which the shutter is oriented to at least partially block the airflow path, and an unactuated position, in which the shutter is out of the airflow path.

The first vent may be one of a first plurality of vents and the second vent may be one of a second plurality of vents.

The first and second vents may be respectively in fluid communication with vents defined in the respective battery pack.

The shutter may be biased toward the actuated position.

Each shutter may be configured to be moved to the unactuated position upon engagement of the respective charger interface by the respective battery pack.

The battery charger may further comprise a fan disposed in the housing and configured to generate an airflow that flows along the airflow path.

The present disclosure provides, in another aspect, a battery charger for charging a battery pack, the battery charger comprising:
a housing;
a charger interface formed on the housing, the charger interface configured to receive and charge the battery pack;
a plurality of vents defined in the housing;
at least one fan disposed in the housing, the fan configured to pull air into the housing through the plurality of vents; and
a shutter disposed adjacent the plurality of vents, the shutter selectively at least partially blocking the plurality of vents.

The shutter may be disposed within the housing.

The shutter may include at least one tab configured to extend outwardly from the housing for engagement by the battery pack.

The shutter may include a comb-like portion.

The plurality of vents may be a first plurality of vents and the shutter may be a first shutter, and wherein the battery charger may further comprise a second plurality of vents and a second shutter selectively at least partially blocking the second plurality of vents.

The charger interface may be disposed at least partially between the first plurality of vents and the second plurality of vents.

The present disclosure provides, in another aspect, battery charger for charging a battery pack, the battery charger comprising:
a housing;
a charger interface formed on the housing, the charger interface configured to receive and charge the battery pack;
a plurality of vents defined in the housing and configured to provide an airflow path defined through the battery pack and the housing;
a shutter disposed adjacent the plurality of vents, the shutter selectively at least partially blocking the airflow path;
an actuator disposed within the housing and configured to move the shutter; and
a controller disposed in the housing, the controller configured to
   determine that the battery pack has made an electrical connection with the charger interface, and
   operate the actuator to move the shutter at least partially out of the airflow path.

The controller may be further configured to
determine whether the battery pack is of a first type or of a second type, and
operate the actuator to move the shutter to at least partially block the airflow path upon determining the battery pack is of the second type.

The controller may be further configured to determine a charging level of the battery pack.

The controller may be further configured to operate the actuator to move the shutter to at least partially block the airflow path upon determining the charging level has reached or exceeded a charging threshold value.

The shutter may be biased toward at least partially blocking the airflow path.

The battery charger may further comprise a fan disposed in the housing and configured to generate an airflow that flows along the airflow path.

The controller may be further configured to
determine a temperature of the battery pack, and
operate the actuator to move the shutter to at least partially block the airflow path upon determining the temperature of the battery pack is below a temperature threshold value.

The battery pack may be a power tool battery pack.

### BRIEF DESCRIPTION OF DRAWINGS

FIG. 1 is a front perspective view of a battery charger and a battery pack of a first type according to an embodiment of the present disclosure.
FIG. 2 is a front perspective view of the battery pack of FIG. 1 electrically connected to the battery charger.
FIG. 3 is a cross-sectional view of the battery charger and the battery pack of FIG. 2, taken along line 3-3 in FIG. 2.
FIG. 4 is a cross-sectional view of the battery charger and the battery pack of FIG. 2, taken along line 4-4 in FIG. 2.
FIG. 5 is a bottom perspective view of the battery pack of FIG. 1.
FIG. 6 is a perspective view of the battery charger of FIG. 1 and a battery pack of a second type.
FIG. 7 is a top view of the battery charger of FIG. 1 with portions removed, the battery charger has shutters positioned within an actuated position.
FIG. 8 is a perspective view of the battery pack of FIG. 6 electrically connected to the battery charger of FIG. 1.
FIG. 9 is a top view of the battery charger of FIG. 1 with portions removed, the shutters of the battery charger are positioned within an unactuated position.
FIG. 10 is a cross-sectional view of the battery charger and the battery pack of FIG. 8, taken along line 10-10 in FIG. 8.
FIG. 11 is a cross-sectional view of the battery charger and the battery pack of FIG. 8, taken along line 11-11 in FIG. 8.
FIG. 12 is a bottom view of the battery pack of FIG. 6.
FIG. 13 is a top view of a battery charger according to another embodiment of the present disclosure, the battery charger has shutters positioned within an actuated position.
FIG. 14 is a top view of the battery charger of FIG. 13, the shutters of the battery charger are positioned within an unactuated position.
FIG. 15 is a front view of a multi-battery pack charger according to another embodiment of the present disclosure.
FIG. 16 is a top view of the multi-battery pack charger of FIG. 15 with battery packs coupled thereto.
FIG. 17 is a top view of the multi-battery pack charger of FIG. 15 with battery packs coupled thereto.
FIG. 18 is a top view of the multi-battery pack charger of FIG. 15 with battery packs coupled thereto.
FIG. 19 is a top view of a multi-battery pack charger according to another embodiment of the present disclosure.
FIG. 20 is a top view of the multi-battery pack charger of FIG. 19 with battery packs coupled thereto.
FIG. 21 is a top view of the multi-battery pack charger of FIG. 19 with battery packs coupled thereto.
FIG. 22 is a top view of a multi-battery pack charger according to another embodiment of the present disclosure.

Before any embodiments of the disclosure are explained in detail, it is to be understood that the disclosure is not limited in its application to the details of construction and the arrangement of components set forth in the following description or illustrated in the following drawings. The disclosure is capable of other embodiments and of being practiced or of being carried out in various ways. Also, it is to be understood that the phraseology and terminology used herein is for the purpose of description and should not be regarded as limiting.

### DETAILED DESCRIPTION

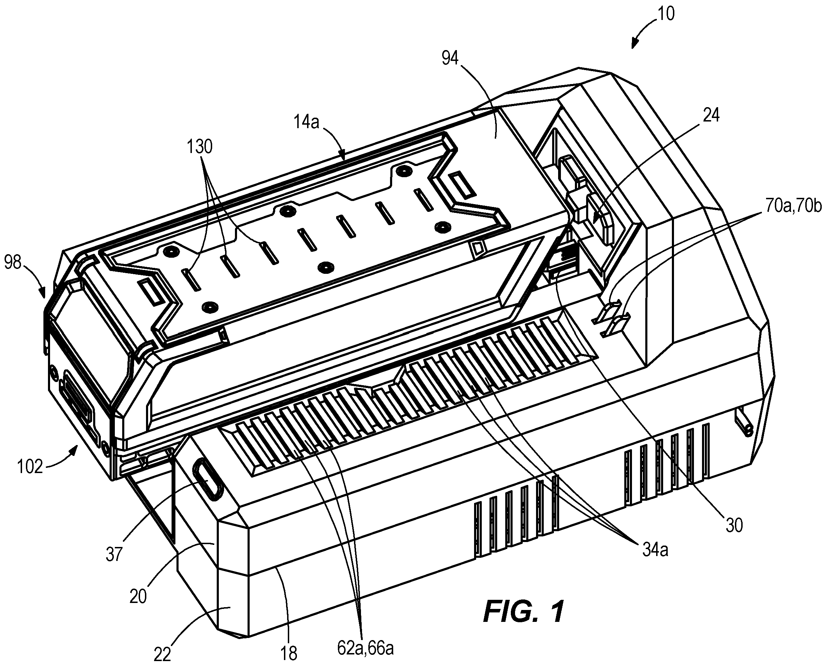

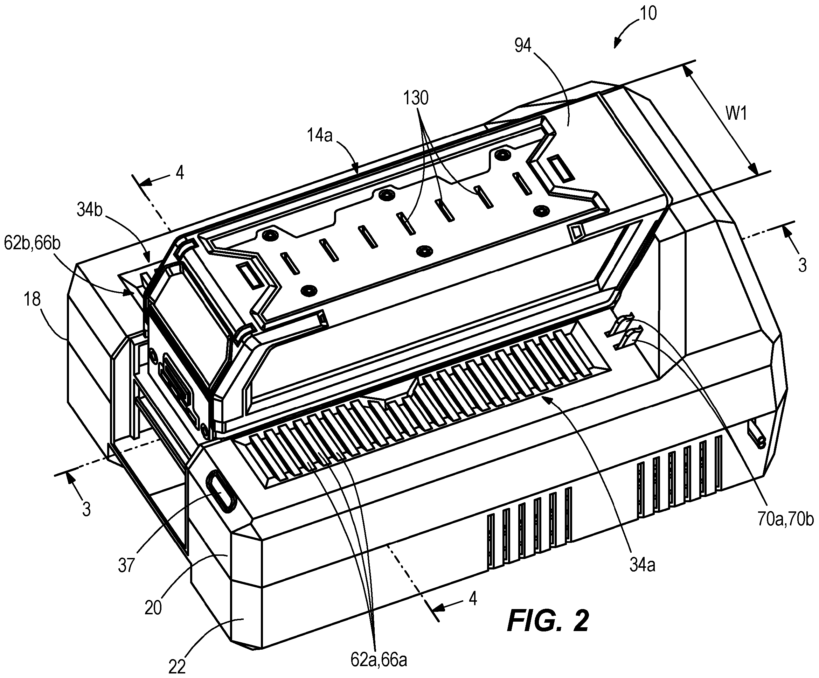

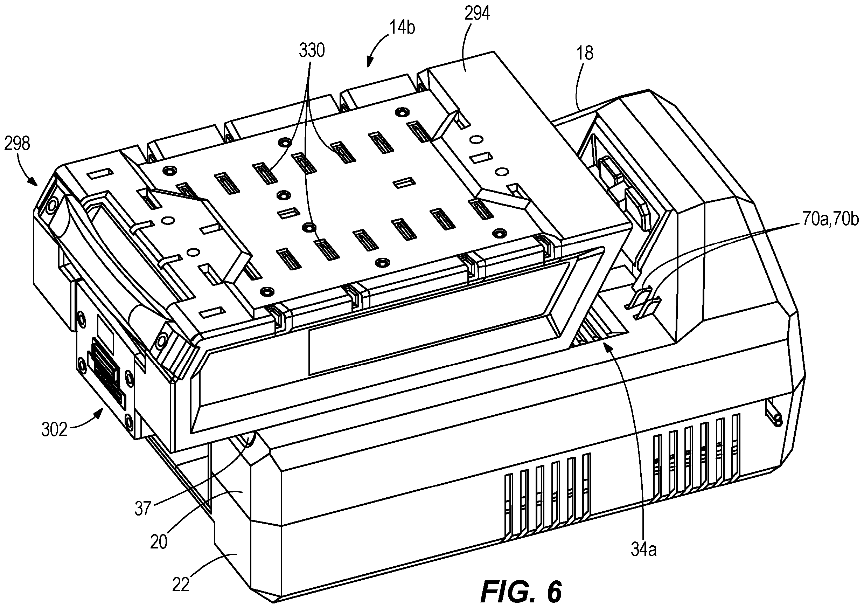

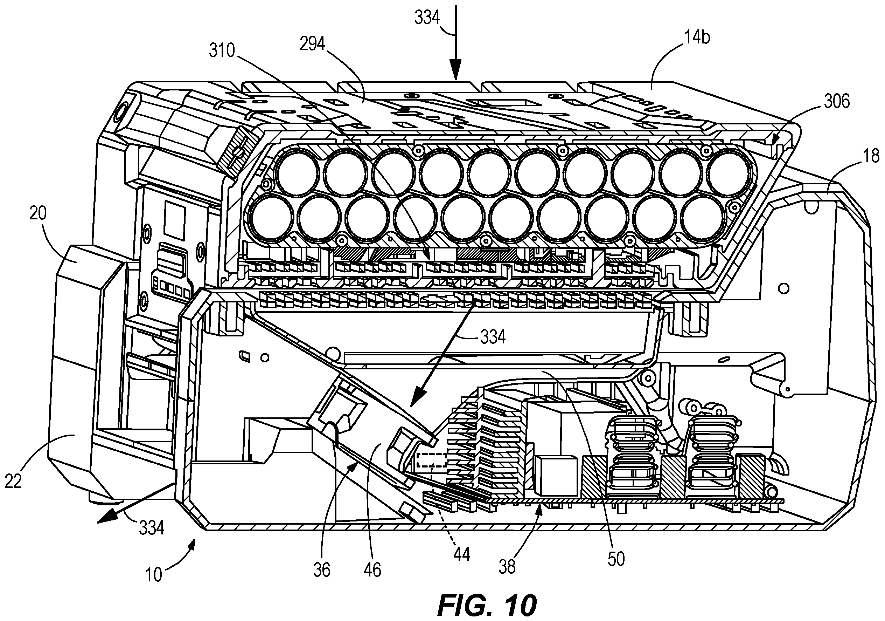

FIGS. 1 and 2 illustrate a battery charger 10 configured to charge various battery packs, such as power tool battery packs. In the illustrated embodiment, the battery charger 10 is operable to charge a first battery pack 14a. In other embodiments, the battery charger 10 is operable to charge a second battery pack 14b (FIGS. 6 and 10).

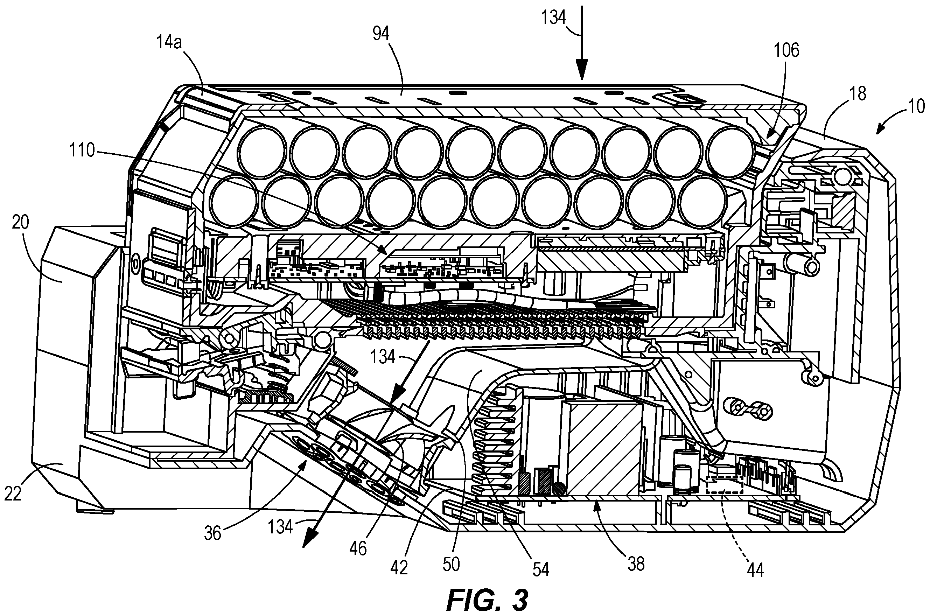

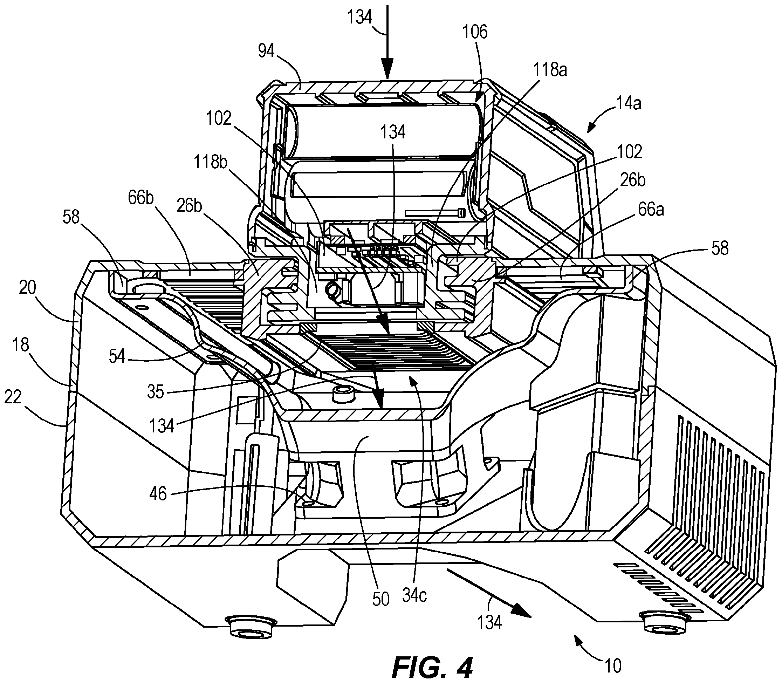

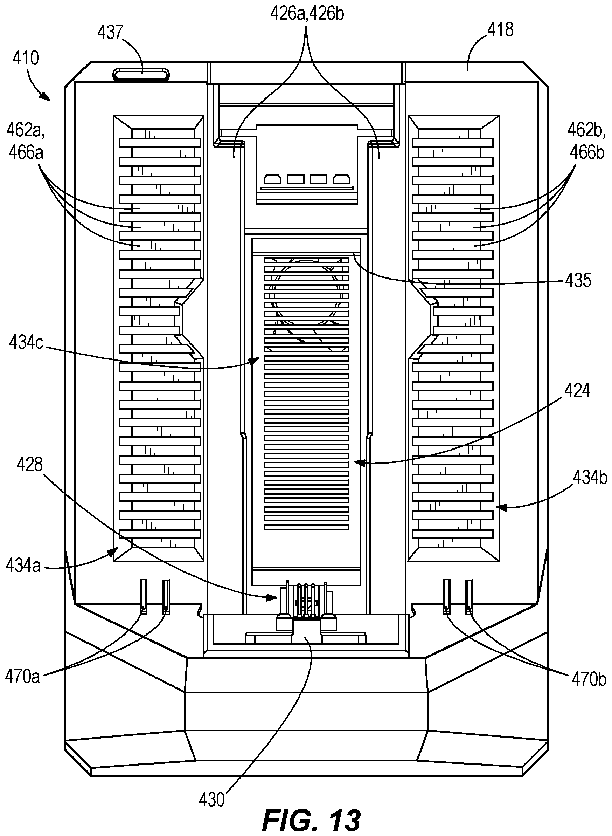

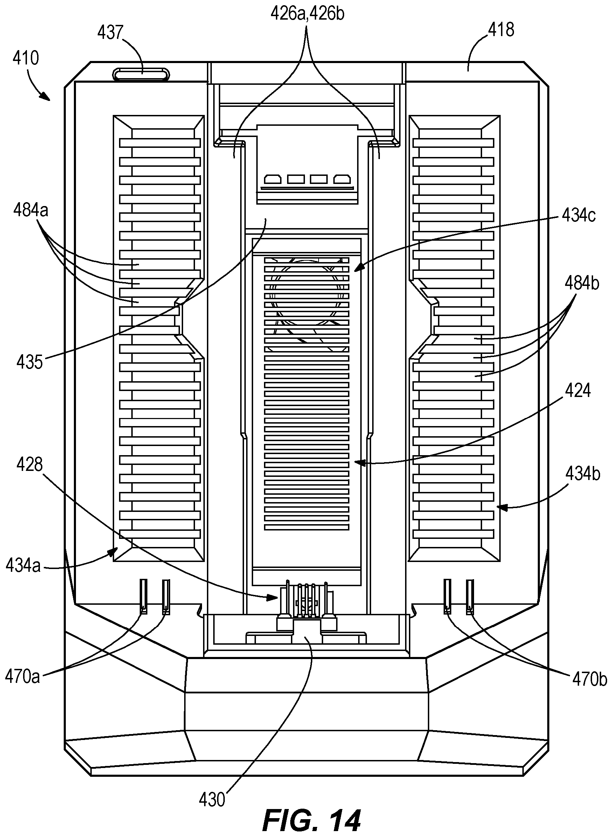

With reference to FIGS. 1-4, the battery charger 10 includes a housing 18 having a top portion 20 and a bottom portion 22 coupled to the top portion 20. A charger interface 24 is disposed on the top portion 20 of the housing 18 and has charger railings 26a, 26b. The charger railings 26a, 26b are spaced apart from each other and configured to engage the first battery pack 14a to slidably couple the first battery pack 14a to the battery charger 10. The charger interface 24 also has a charger terminal block 30 with a set of charger terminals (e.g., charger terminals 428, FIGS. 13 and 14) configured to electrically connect the battery charger 10 to the first battery pack 14a for a charging operation. Further, the housing 18 includes a first plurality of inlet vents 34a, a second plurality of inlet vents 34b, and a third plurality of inlet vents 34c. The first and second plurality of inlet vents 34a, 34b are defined along each side of the charger interface 24. The third plurality of inlet vents 34c is defined along a surface 35 of the charger interface 24. The housing 18 of the battery charger 10 also includes a plurality of outlet vents 36 (FIG. 3) defined along the bottom portion 22 of the housing 18. The inlet vents 34a-c and the outlet vents 36 are configured to allow air to enter and be exhausted from the housing 18 of the battery charger 10.

The battery charger 10 further includes a power button 37 disposed on the top portion 20 of the housing 18 and charger electronics 38 supported within the bottom portion 22 of the housing 18. The power button 37 is configured to be pressed by a user to actuate the battery charger 10. The charger electronics 38 are configured to output a charging current through the charger interface 24 to charge the first battery pack 14a. The charger electronics 38 include, among other things, a printed circuit board (PCB) 42, a microcontroller 44 and a charging circuit for the charger terminals. The microcontroller 44 includes an electronic processor and a memory storing instructions that are executed by the electronic processor to implement various functions of the microcontroller 44.

Additionally, the battery charger 10 includes a fan 46 supported within the bottom portion 22 of the housing 18 and disposed adjacent the charger electronics 38. The fan 46 is in fluid communication with the inlet vents 34a-c via an air guide conduit 50 coupled to the top portion 20 of the housing 18. The air guide conduit 50 includes a body 54 and a flange 58 extending from the body 54 to abut the top portion 20 of the housing 18. The air guide conduit 50 is disposed directly under the inlet vents 34a, 34b, and thereby surrounds a periphery of the inlet vents 34a-c to capture an airflow that enters the inlet vents 34a-c. The body 54 of the air guide conduit 50 is also coupled to a portion of the fan 46 to further place the fan 46 in fluid communication with the inlet vents 34a-c. In the illustrated embodiment, the fan 46 is an axial fan. The fan 46 is configured to pull air through the first battery pack 14a and the housing 18 of the battery charger 10 to generate an airflow that travels through the first battery pack 14a and the battery charger 10. Eventually, the airflow is directed toward the charger electronics 38 for cooling purposes and goes through the fan 46 to be exhausted from the battery charger 10 via the outlet vents 36 of the battery charger 10.

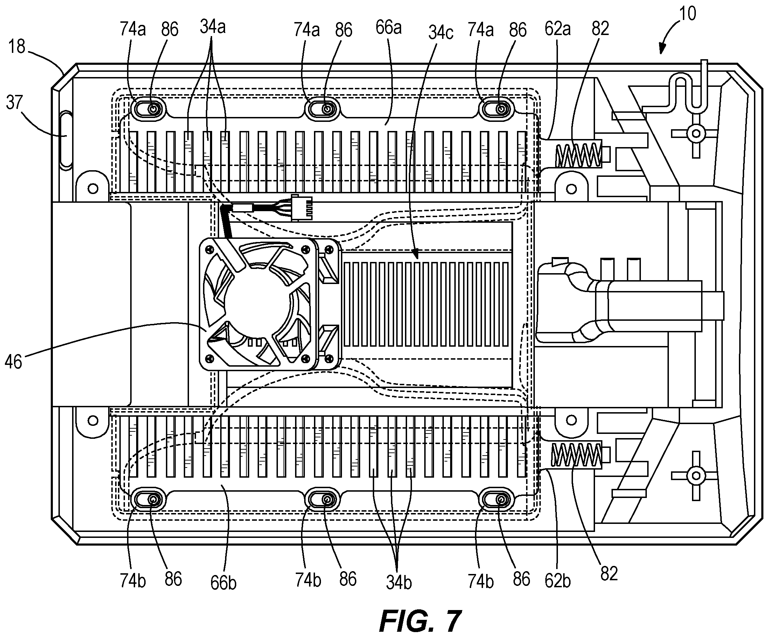

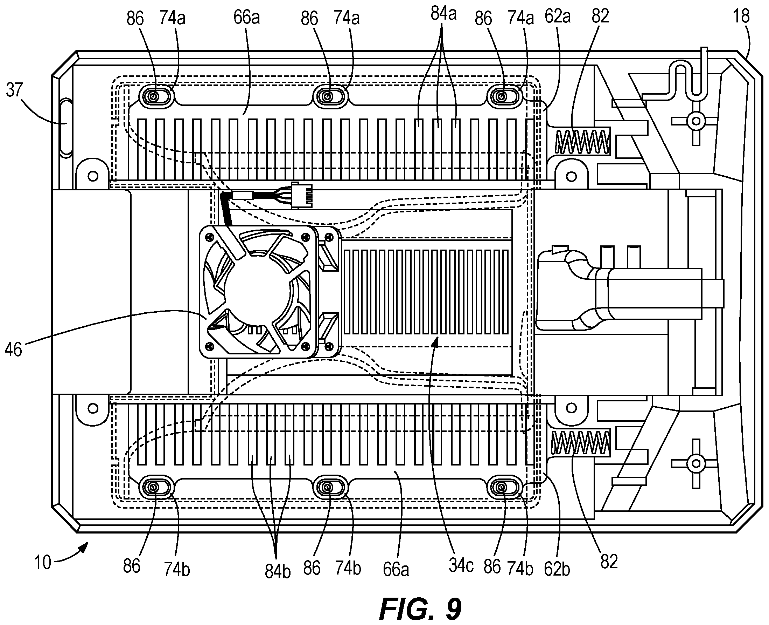

With continued reference to FIGS. 1-4, the battery charger 10 includes a pair of shutters 62a, 62b that are respectively disposed below the first and second plurality of inlet vents 34a, 34b. Each shutter 62a, 62b includes a comb-like portion 66a, 66b and a pair of tabs 70a, 70b extending through the top portion 20 of the housing 18 of the battery charger 10. The comb-like portion 66a, 66b of each shutter 62a, 62b has three tabs 74a, 74b (FIGS. 7 and 9). The shutters 62a, 62b are slidably coupled to the top portion 20 of the housing 18 and configured to block an airflow from flowing through the first and second plurality of inlet vents 34a, 34b.

The shutters 62a, 62b are configured to slidably move between an actuated position (FIG. 7) and an unactuated position (FIG. 9). In the actuated position, springs 82 are provided to bias each shutter 62a, 62b such that the tabs 70a, 70b extend through the housing 18. Additionally, the comb-like portion 66a, 66b of each shutter 62a, 62b is respectively disposed within openings 84a, 84b defined by the first and second plurality of inlet vents 34a, 34b to block the inlet vents 34a, 34b. Multiple pins 86 are provided to extend through each tab 74a, 74b so that a first side of each tab 74a, 74b abuts a respective pin 86 to place each shutter 62a, 62b in the actuated position. As such, the shutters 62a, 62b are positioned to block the inlet vents 34a, 34b and prevent the airflow from flowing through the inlet vents 34a, 34b. In the unactuated position, the shutters 62a, 62b are moved in a rearward direction, represented by arrow 90. A second side of each tab 74a, 74b abuts the respective pin 86 to place each shutter 62a, 62b in the unactuated position. The tabs 70a, 70b are pushed into the housing 18 of the battery charger 10. The comb-like portion 66a, 66b of each shutter 62a, 62b is positioned to align with the inlet vents 34a, 34b to expose the openings 84a, 84b. As such, the airflow is allowed to flow through the first and second plurality of inlet vents 34a, 34b when the shutters 62a, 62b no longer block the inlet vents 34a, 34b.

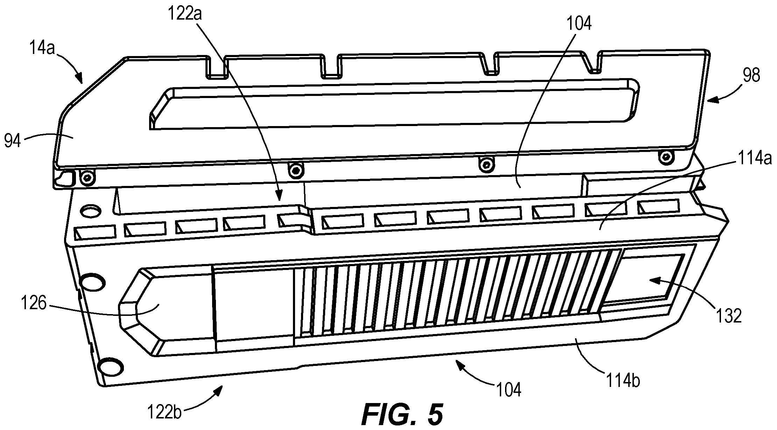

With reference to FIGS. 1-5, the first battery pack 14a includes a housing 94 having a top portion 98 and a bottom portion 102. The first battery pack 14a is a small battery pack and defines a first battery width W 1. The housing 94 supports a plurality of battery cells 106 and battery pack electronics 110. A battery pack interface (not shown) is disposed on the housing 94 of the first battery pack 14a and includes a terminal block (not shown) that is engageable with the charger terminal block 30 of the battery charger 10 to electrically connect the first battery pack 14a to the battery charger 10. Battery railings 114a, 114b respectively extend from a pair of walls 118a, 118b that are integrally formed with a first bottom surface 104 of the housing 94. As such, grooves 122a, 122b (FIGS. 5) are individually defined between the battery railings 114a, 114b and first bottom surface 104. The battery railings 114a, 114b are interconnected by a second bottom surface 126 of the housing 94. The first battery pack 14a further includes a plurality of inlet vents 130 defined at the top portion 98 of the housing 94 and a plurality of outlet vents 132 defined along the second bottom surface 126.

When the first battery pack 14a is coupled to the battery charger 10, the battery railings 114a, 114b and the grooves 122a, 122b of the first battery pack 14a are configured to cooperate with the charger railings 26a, 26b of the battery charger 10. In particular, the charger railings 26a, 26b are received within the grooves 122a, 122b of the first battery pack 14a to slidably couple the first battery pack 14a to the battery charger 10. Once the first battery pack 14a is electrically connected to the battery charger 10, the second bottom surface 126 of the first battery pack 14a is oriented above the third plurality of inlet vents 34c to place the outlet vents 132 of the first battery pack 14a in fluid communication with the third plurality of inlet vents 34c. An airflow path is then defined between the battery charger 10 and the first battery pack 14a. The small structure of the first battery pack 14a prevents the housing 94 from engaging the tabs 70a, 70b of each shutter 62a, 62b. As such, the shutters 62a, 62b remain in the actuated position when the first battery pack 14a is coupled to the battery charger 10.

During a charging operation, the fan 46 of the battery charger 10 is configured to pull air through the first battery pack 14a and into the housing 18 of the battery charger 10. Specifically, the fan 46 generates an airflow 134 configured to flow through the inlet vents 130 of the first battery pack 14a and into the housing 94 to cool the battery cells 106 and the battery pack electronics 110. The airflow 134 is then directed to be exhausted from the housing 94 of the first battery pack 14a via the outlet vents 132. After that, the airflow 134 is directed to flow into the housing 18 of the battery charger 10 via the third plurality of inlet vents 34c. The airflow 134 is then directed toward the charger electronics 38 for cooling purposes and through the fan 46 to be exhausted from the battery charger 10 via the outlet vents 36. As the shutters 62a, 62b remain in the actuated position, a cooling efficiency and a cooling performance of the first battery pack 14a is maximized. Also, keeping the first and second plurality of inlet vents 34a, 34b closed when not in use will further provide ingress protection for the battery charger 10. Additionally, leakage of the airflow 134 from the first and second plurality of inlet vents 34a, 34b can be minimized.

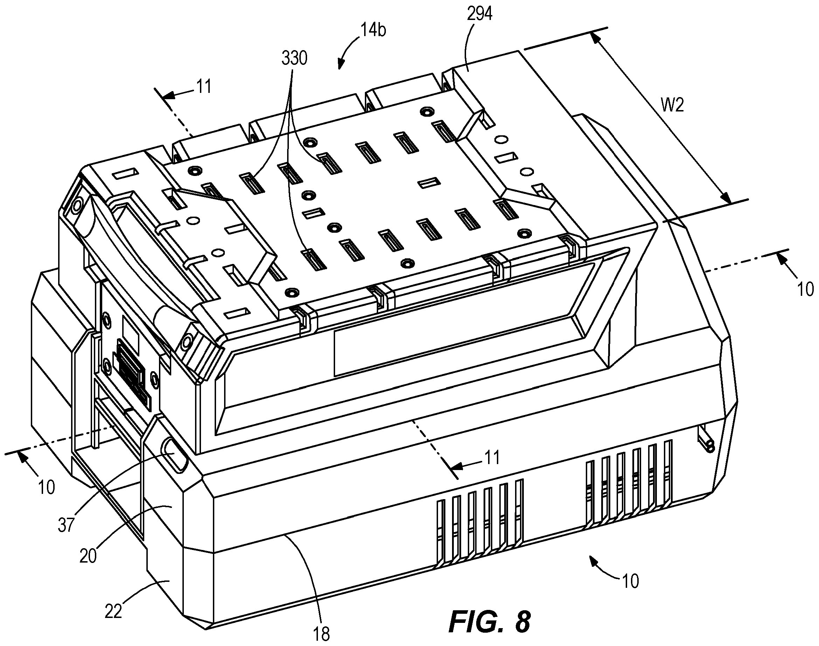

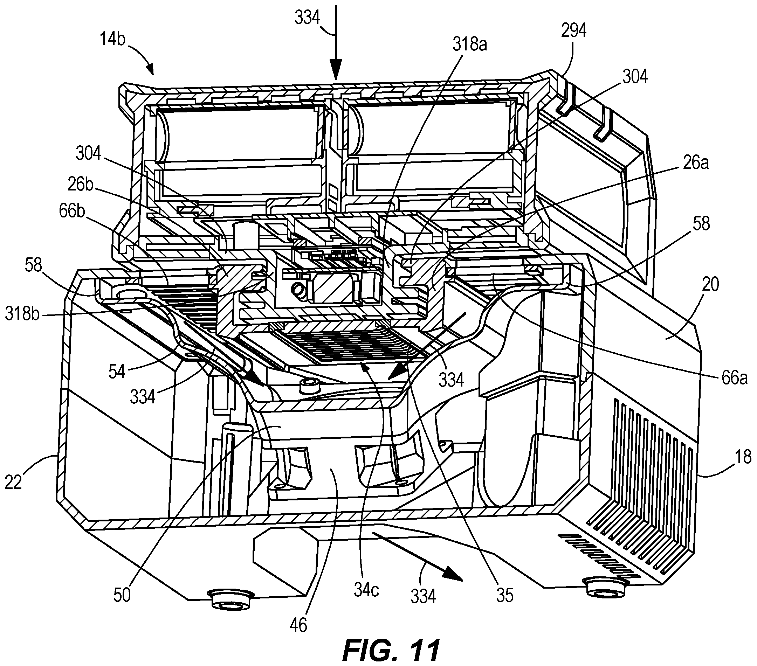

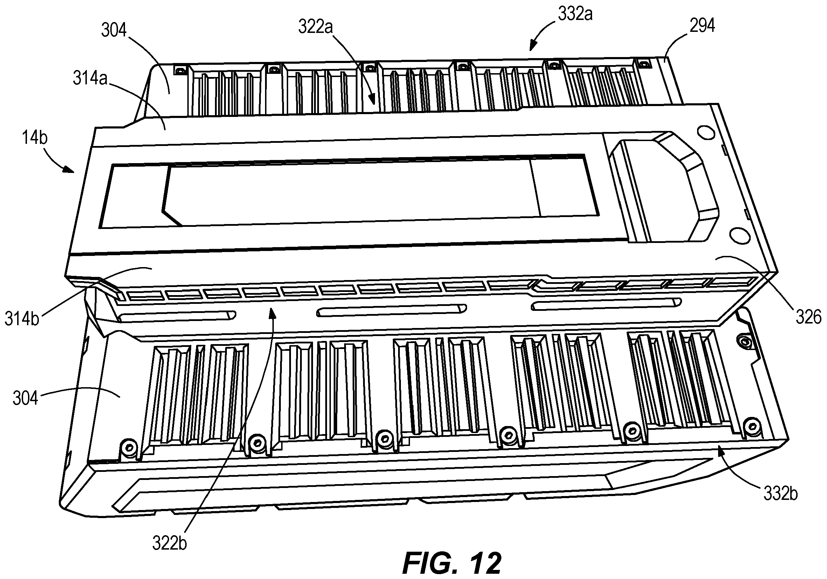

With reference to FIGS. 6-12, the second battery pack 14b is coupled to the battery charger 10 of FIGS. 1-4. The second battery pack 14b is similar to the first battery pack 14a of FIGS. 1-5; therefore, like structure will be identified by like reference number plus "200" and only the differences will be discussed hereafter.

In the embodiment of FIGS. 6-12, the second battery pack 14b is a large battery pack and defines a second battery width W2 greater than the first battery width W1 of the first battery pack 14a. The second battery pack 14b has a first plurality of outlet vents 332a and a second plurality of outlet vents 332b that are defined along the first bottom surface 304. The outlet vents 332a, 332b are configured to exhaust air from the housing 294 of the second battery pack 14b. When the second battery pack 14b is electrically connected to the battery charger 10, the first bottom surface 304 is oriented to extend above the top portion 20 of the battery charger 10 to place the outlet vents 332 of the second battery pack 14b in fluid communication with the first and second plurality of inlet vents 34a, 34b. The housing 294 of the second battery pack 14b engages the tabs 70a, 70b of each shutter 62a, 62b, and thereby places the shutters 62a, 62b in the unactuated position. As such, the openings 84a, 84b of the first and second plurality of inlet vents 34a, 34b are exposed to define an airflow path between the second battery pack 14b and the battery charger 10.

During a charging operation of the second battery pack 14b, the fan 46 of the battery charger 10 is configured to pull air through the second battery pack 14b and into the housing 18 of the battery charger 10. Specifically, the fan 46 generates an airflow 334 configured to flow through the inlet vents 330 of the second battery pack 14b and into the housing 294 to cool the battery cells 306 and the battery pack electronics 310. The airflow 334 is then exhausted from the housing 294 of the second battery pack 14b via the outlet vents 332a, 332b. After that, the airflow 334 is directed to flow into the housing 18 of the battery charger 10 via the first and second plurality of inlet vents 34a, 34b. The airflow 334 is then directed toward the charger electronics for cooling purposes and through the fan 46 to be exhausted from the battery charger 10 via the outlet vents 36.

Ultimately, the battery charger 10 is configured to charge battery packs having various sizes and vent locations. As such, the first and second plurality of inlet vents 34a, 34b are selectively blocked depending on the size of a battery pack. Further, selectively blocking the inlet vents 34a, 34b allows the battery charger 10 to accommodate battery packs having similar battery interfaces and different vent locations. Large battery packs, like the second battery pack 14b, will move the shutters 62a, 62b to unblock the inlet vents 34a, 34b. Small battery packs, like the first battery pack 14a, will not engage the shutters 62a, 62b and cause the shutters 62a, 62b to remain in the actuated position to block the inlet vents 34a, 34b.

With reference to FIGS. 13 and 14, another embodiment of a battery charger 400 is illustrated. The battery charger 400 is similar to the battery charger 10 of FIGS. 1-4; therefore, like structure will be identified by like reference number plus "400" and only the differences will be discussed hereafter. The battery charger 400 functions similar to the battery charger 10 of FIG. 1-4. Although, the battery charger 400 is smaller than the battery charger 10 of FIGS. 1-4.

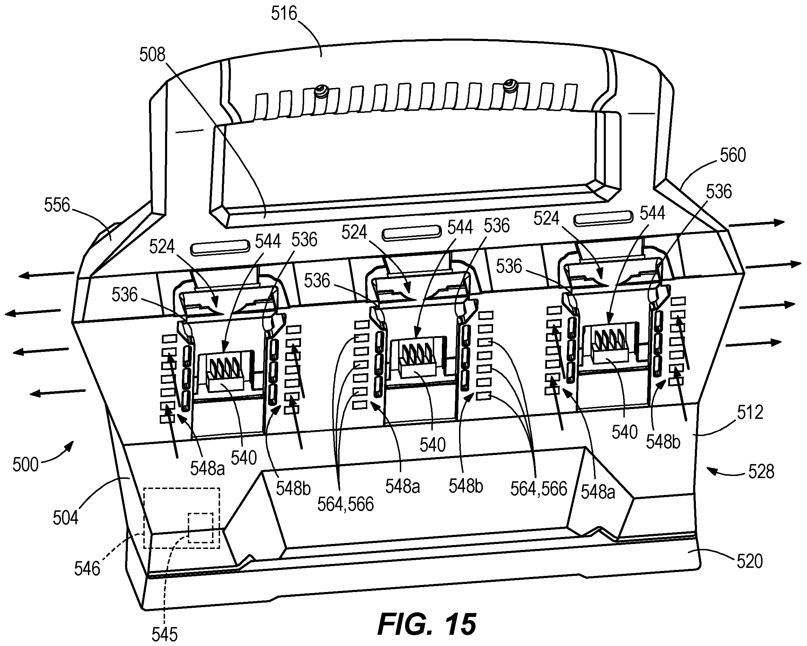

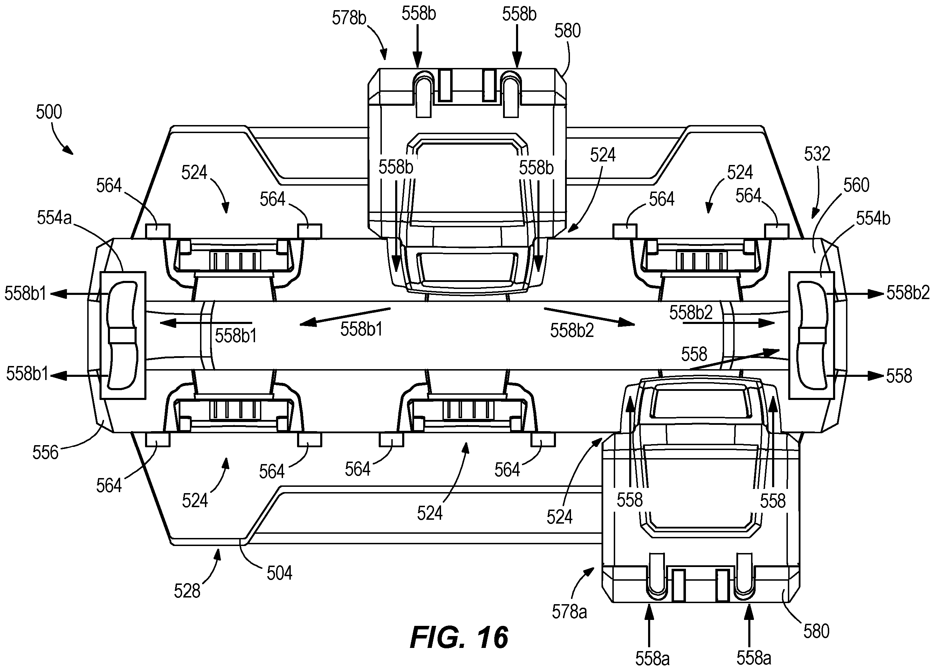

With reference to FIGS. 15 and 16, a multi-battery pack charger 500 is illustrated. The charger 500 includes a housing 504 having a top portion 508 and a bottom portion 512, a handle 516 integrally formed with the top portion 508, and a base 520 disposed on the bottom portion 512. The handle 516 is configured to be grasped by a user to transport the charger 500.

The charger 500 further includes a plurality of charger interfaces 524 formed on the housing 504. The charger interfaces 524 are disposed on a front side 528 and a rear side 532 of the housing 504. In the illustrated embodiment, there are three charger interfaces 524 on the front side 528 of the charger 500 and three charger interfaces 524 on the rear side 532 of the charger 500. Each charger interface 524 includes charger railings 536 and a charger terminal block 540 with charger terminals 544 configured to electrically connect each charger interface 524 to a respective battery pack for a charging operation. The charger railings 536 are disposed on opposite sides of the charger terminal block 540. Charger electronics 546 are disposed within the housing 504 of the charger 500 and configured to output a charging current through each charger interface 524 to charge individual battery packs. The charger electronics may include a printed circuit board (PCB), a microcontroller 545, and a charging circuit (not shown) for each charger terminal block 540 such that each battery pack may be charged simultaneously and independently.

Moreover, the charger 500 includes multiple sets of inlet vents, a plurality of outlet vents (not shown), a first fan 554a, and a second fan 554b. A plurality of inlet vents 548a, 548b are respectively defined on the sides of each charger interface 524. The outlet vents are also defined on a first side 556 of the charger 500 and a second side 560 of the charger 500. The first fan 554a is disposed on the first side 556 of the charger 500 and the second fan 554b is disposed on the second side 560 of the charger 500. As such, the first and second fans 554a, 554b are in fluid communication with each plurality of inlet vents 548a, 548b and each plurality of outlet vents.

A pair of shutters 564 are also provided to block a respective plurality of inlet vents 548a, 548b to prevent air from entering the housing 504 of the charger 500. Each shutter 564 has a comb-like structure (not shown) with tabs 566 configured to extend through openings of each plurality of inlet vents 548a, 548b. In an actuated position, the shutters 564 are configured to be biased by a biasing member (not shown) toward corresponding inlet vents 548a, 548b, such that the shutters 564 extend through the corresponding inlet vents 548a, 548b. In an unactuated position, the shutters 564 are configured to be pushed into the housing 504 of the charger 500 to expose the openings of the corresponding inlet vents 548a, 548b. An airflow is then permitted to pass through the corresponding inlet vents 548a, 548b.

FIG. 16 illustrates two battery packs 578a, 578b electrically connected to the charger interfaces 524. Each battery pack 578a, 578b includes a housing 580 having a top portion and a bottom portion. A plurality of battery cells (not shown) and battery pack circuitry are disposed within the housing 580 of each battery pack 578. A battery pack interface (not shown) is disposed on the housing 580 and has a terminal block engageable with the charger terminal blocks 540. Each battery pack 578a, 578b also includes railings (not shown) that cooperate with the charger railings 536 to slidably couple the battery packs 578a, 578b to the charger 500. A first plurality of vents (not shown) is defined on the bottom portion of each battery pack 578a, 578b. Also, a second plurality of vents (not shown) is defined on the top portion of each battery pack 578a, 578b and adjacent the battery pack interface. When the battery packs 578a, 578b are coupled to charger 500, the battery packs 578a, 578b are oriented such that the second plurality of vents is positioned to align and be in fluid communication with the inlet vents 548a, 584b of corresponding charger interfaces 524.

During a charging operation, the battery packs 578a, 578b are electrically connected to the charger interfaces 524 to be charged. When the battery packs 578a, 578b are inserted into the charger interfaces 524, the housing 580 of each battery pack 578 engages corresponding shutters 564 and moves the shutters 564 into the unactuated position. Corresponding inlet vents 548a, 548b are placed in fluid communication with the second plurality of vents of the battery packs 578a, 578b, and thereby provide airflow paths that are defined between the battery packs 578a, 578b and the housing 504 of the charger 500. Shutters 564 that are disposed at other charger interfaces 524 without battery packs remain in the actuated position. As the battery packs 578a, 578b are charging, the fans 554a, 554b are operable to pull air through the battery packs 578a, 578b and into the housing 504 of the charger 500. The fans 554a, 554b generate various airflows depending on the location of one or more battery packs electrically connected to the charger 500.

In the illustrated embodiment, the fans 554a, 554b generate a first airflow 558a and a second airflow 558b. The first airflow 558a is configured to flow through the first plurality of vents of the first battery pack 578a and into the housing 580 to cool the battery circuitry and the battery cells. The first airflow 558a is then exhausted from the first battery pack 578a via the second plurality of vents. After that, the first airflow 558a goes directly through corresponding inlet vents 548a, 548b to enter the charger 500. Since the first battery pack 578a is disposed adjacent the second fan 554b, the first airflow 558a is directed toward the second fan 554b. As such, the first airflow 558a is exhausted from the charger 500 via the outlet vents defined on the second side 560 of the charger 500.

The second airflow 558b is configured to flow into the first plurality of vents of the second battery pack 578b and flow out of the second plurality of vents of the second battery pack 578b to cool the battery circuitry and the battery cells. The second airflow 558b is then pulled through corresponding inlet vents 548a, 548b disposed at a center of the charger 500. As the second airflow 558b flows through the housing 504 of the charger 500, the second airflow 558b is split into two separate airflow portions 558b1, 558b2 on account of the fans 554a, 554b being oppositely disposed of the second battery pack 578b. Specifically, a first airflow portion 558b1 is directed toward the first fan 554a to be exhausted from the charger 500 via the outlet vents defined on the first side 556 of the charger 500. A second airflow portion 558b2 is directed toward the second fan 554b to be exhausted from the charger 500 via the outlet vents defined on the second side 560 of the charger 500.

The charger 500 is configured to only provide a cooling operation at charger interfaces 524 that are electrically connected to a battery pack. As such, the shutters 564 are configured to block airflow from going through inlet vents 548a, 548b that are disposed at charger interfaces 524 without battery packs. As such, airflow leakage is prevented to improve cooling efficiency of the battery packs 578a, 578b that are electrically connected to the charger 500. Also, the quantity of fans 554a, 554b provided within the charger 500 can be reduced. The fans 554a, 554b that are disposed within the charger 500 can be low-powered fans.

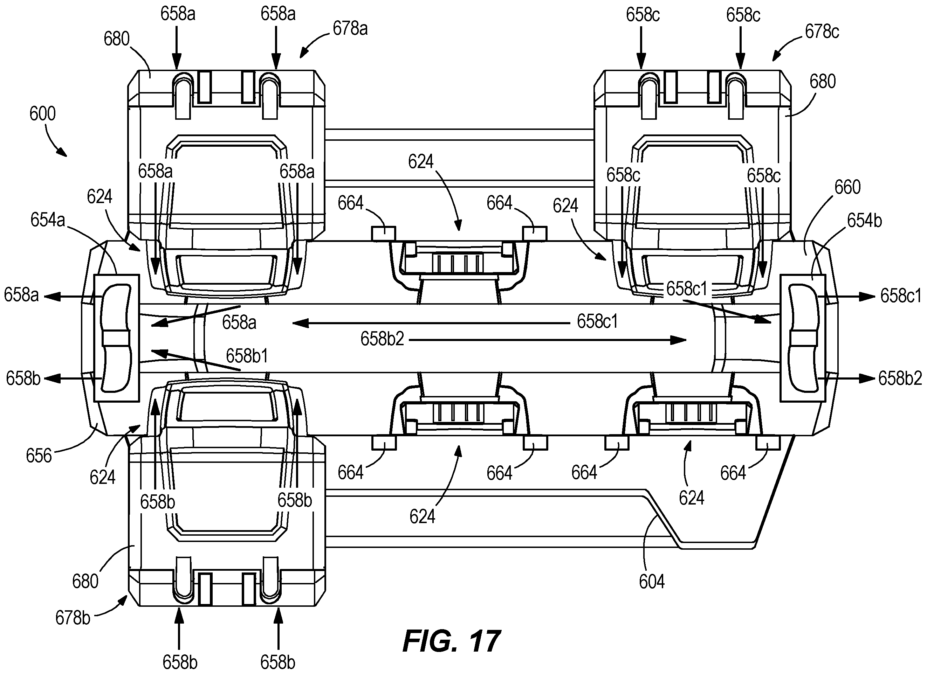

With reference to FIG. 17, another embodiment of battery packs 678 electrically connected to a multi-battery pack charger 600 is illustrated. The illustrated embodiment is similar to the embodiment of FIGS. 15 and 16; therefore, like structure will be identified by like reference number plus "100" and only the differences will be discussed hereafter.

In the embodiment of FIG. 17, a first battery pack 678a, a second battery pack 678b, and a third battery pack 678c are electrically connected to the charger interfaces 624 that are disposed on the first side 656 and the second side 660 of the charger 600. During a charging operation, the fans 654a, 654b generate a first airflow 658a, a second airflow 658b, and a third airflow 658c. Specifically, the first airflow 658a is configured to flow in and out of the first battery pack 678a via first and second plurality of vents (not shown) defined in the first battery pack 678a. The first airflow 658a then flows directly through inlet vents (not shown) of a corresponding charger interface 624 to enter the housing 604 of the charger 600. As the first airflow 658a flows through the charger 600, the first airflow 658a is directed toward the first fan 654a to be exhausted from the charger 600 via outlet vents (not shown) defined on the first side 656 of the charger 600.

The second airflow 658b is similar to the first airflow 658a as discussed above. Although, the second airflow 658b is configured to flow through the second battery pack 678b. Also, the second airflow 658b is split into two separate airflow portions 658b1, 658b2 to be exhausted from the outlet vents at the first and second sides 656, 660 of the charger 600. The third airflow 658c is also similar to the first airflow 658a as discussed above. Although, the third airflow 658c is configured to flow through the third battery pack 678c. The third airflow 658c is also split into two separate airflow portions 658c1, 658c2 to be exhausted from the outlet vents at the first and second sides 656, 660 of the charger 600.

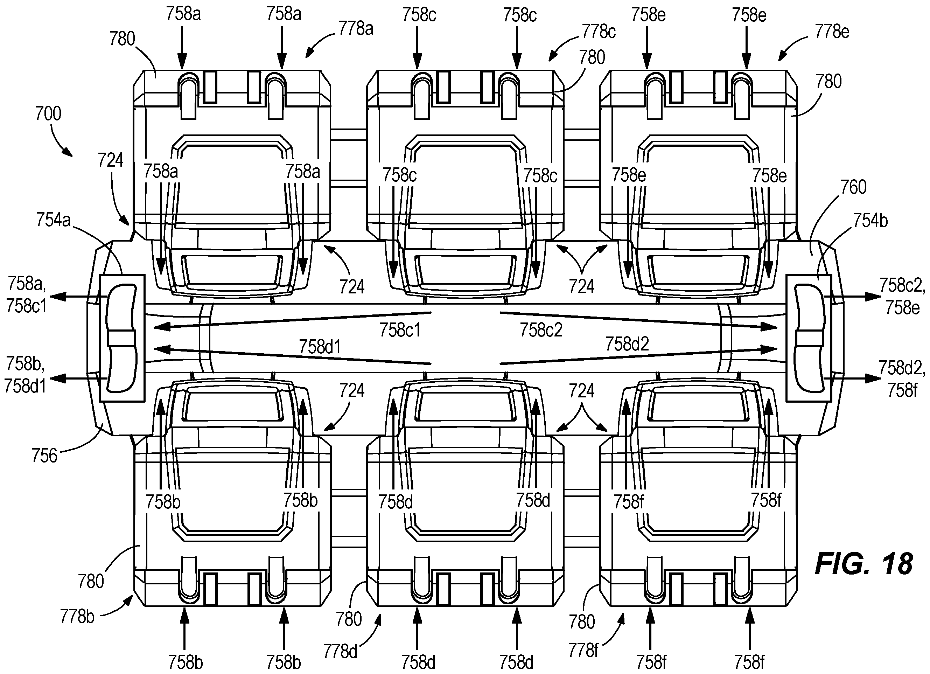

With reference to FIG. 18, another embodiment of battery packs 778a-f electrically connected to a multi-battery pack charger 700 is illustrated. The illustrated embodiment is similar to the embodiment of FIGS. 15 and 16; therefore, like structure will be identified by like reference number "200" and only the differences will be discussed hereafter.

In the embodiment of FIG. 18, each charger interface 724 of the charger 700 is electrically connected to a battery pack 778a-f. During a charging operation, the fans 754a, 754b generate multiple airflows 758a-f configured to flow along an airflow path respectively defined between the housing 704 of the charger 700 and each battery pack 778a-f. For example, the first airflow 758a is configured to flow through a first battery pack 778a disposed at the first side 756 of the charger 700. The first airflow 758a flows in and out of the first battery pack 778a to then flow directly into housing 704 of the charger 700 via inlet vents (not shown) defined at a corresponding charger interface 724. As the first airflow 758a flows through the charger 700, the first airflow 758a is directed toward the first fan 754a to be exhausted from outlet vents (not shown) on the first side 756 of the charger 700. The second airflow 758b is similar to the first airflow 758a as discussed above. However, the second airflow 758b is configured to flow through a second battery pack 778b disposed opposite the first battery pack 778a.

The third airflow 758c is configured to flow through a third battery pack 778c disposed at the center of the charger 700. As such, the third airflow 758c flows in and out of the third battery pack 778c to then flow directly into the housing 704 of the charger 700 via the inlet vents defined at a corresponding charger interface 724. The third airflow 758c is then split into two separate airflow portions 758c1, 758c2 that are configured to be exhausted from the outlet vents defined on the first and second sides 756, 760 of the charger 700. The fourth airflow 758d is similar to the third airflow 758c as discussed above. However, the fourth airflow 758d is configured to flow through a fourth battery pack 778d disposed opposite the third battery pack 778c.

The fifth airflow 758e is configured to flow through a fifth battery pack 778e disposed at the second side 760 of the charger 700. The fifth airflow 758e flows in and out of the fifth battery pack 778e to then flow directly into housing 704 of the charger 700 via the inlet vents defined at a corresponding charger interface 724. As the fifth airflow 758e flows through the charger 700, the fifth airflow 758e is directed toward the second fan 754b to be exhausted from the outlet vents on the second side 760 of the charger 700. The sixth airflow 758f is similar to the fifth airflow 758e as discussed above. However, the sixth airflow 758f is configured to flow through a sixth battery pack 778f disposed opposite the fifth battery pack 778e.

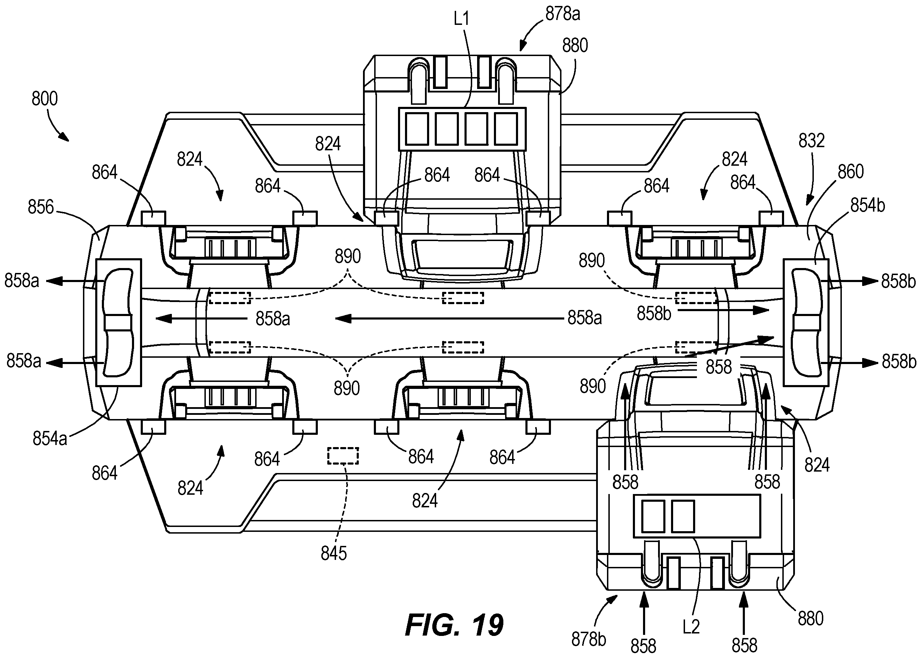

With reference to FIG. 19, another embodiment of battery packs 878a, 878b electrically connected to a multi-battery pack charger 800 is illustrated. The illustrated embodiment is similar to the embodiment of FIGS. 15 and 16; therefore, like structure will be identified by like reference number plus "300" and only the differences will be discussed hereafter.

In the illustrated embodiment, a first battery pack 878a and a second battery pack 878b are electrically connected to the charger interfaces 824 for a charging operation. The charger 800 further includes an actuator 890 (e.g., a solenoid, a motor, or the like) for each charger interface 824. Each actuator 890 is configured to engage the shutters 864 provided at a corresponding charger interface 824. Initially, the shutters 864 are biased into the actuated position by a biasing member. When activated, the actuator 890 moves the shutters 864 to the unactuated position. When the actuator 890 is operated, the shutters 864 are then biased back into the actuated position by the biasing member. In other embodiments, the actuators 890 may move the shutters 864 between the actuated position and the unactuated position.

During a charging operation, the microcontroller 845 receives a first signal from each battery pack 878a, 878b. The first signal indicates that the first and second battery packs 878a, 878b have made an electrical connection with the charger interfaces 824. The charging current is then permitted to be outputted through the charger interfaces 824 to charge the battery packs 878a, 878b. After receiving the first signal, the microcontroller 845 activates a respective actuator 890 to move the corresponding shutters 864 to the unactuated position. As such, an airflow path is respectively defined between the battery packs 878a, 878b and the housing 804 of the charger 800 to cool the battery circuitry and the battery cells.

The illustrated embodiment shows a first charging level L1 of the first battery pack 878a and a second charging level L2 of the second battery pack 878b after a time period has passed. The first charging level L1 indicates that the first battery pack 878a has reached or exceeded a charging threshold value (i.e., fully charged). As such, the first battery pack 878a sends a second signal to the microcontroller 845 to indicate that the first battery pack 878a has reached or exceeded the charging threshold value. The microcontroller 845 operates the actuator 890 to allow the shutters 864 of the corresponding charger interface 824 to be biased toward the actuated position and block an airflow from flowing through the first battery pack 878a and the charger 800. In the other embodiment, the microcontroller 845 operates the actuator 890 to move the shutters 864 to the actuated position. The second charging level L2 indicates that the second battery pack 878b is below the charging threshold value (i.e., not fully charged). As such, the shutters 864 for the corresponding charger interface 824 remain in the unactuated position.

The fans 854a, 854b generate an airflow 858 configured to flow through the second battery pack 878b via the defined in the second battery pack 878b. The airflow 858 then flows into the housing 804 of the charger 800 via inlet vents defined at a corresponding charger interface 824. As the airflow 858 flows through the charger 800, the airflow 858 is split into two separate airflow portions 858a, 858b to be exhausted from outlet vents defined at the first and second sides 856, 860 of the charger 800.

The actuators 890 provided within the battery charger 800 are configured to move the shutters 864 based on a charging level of the battery packs 878a, 878b. As such, blocking the inlet vents of a respective charger interface 824 with a fully charged battery pack will improve the cooling efficiency of other charger interfaces 824 with partially charged battery packs. Also, blocking the inlet vent of the respective charger interface 824 will prevent the leakage of the airflows provided for the other charger interfaces 824. The quantity of fans provided within the charger 500 can also be reduced such that the fans 854a, 854b can be low-powered fans.

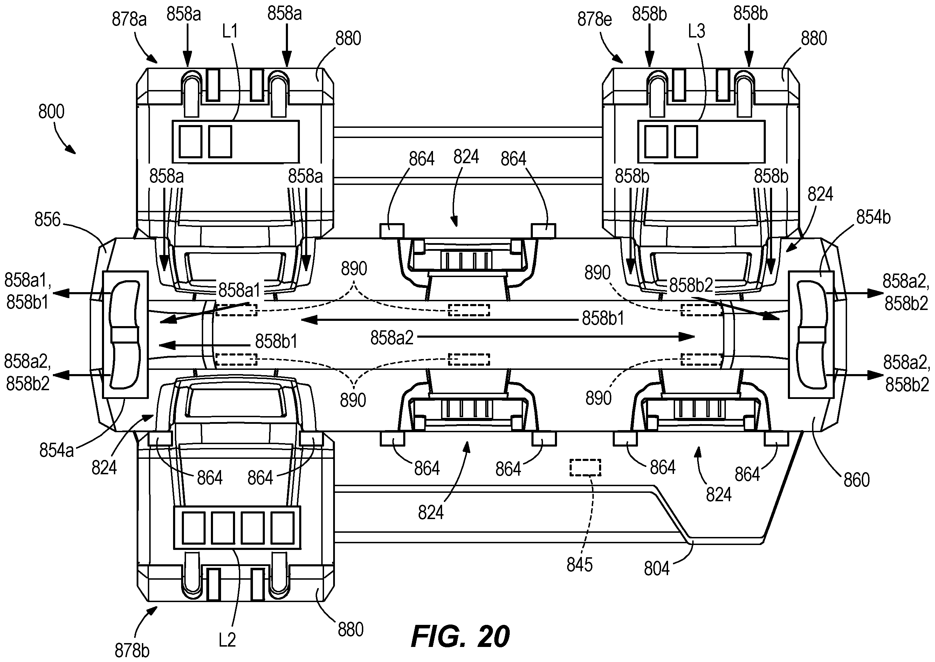

FIG. 20 illustrates an alternative embodiment of the battery packs 878 and the multi-battery pack charger 800 of FIG. 19. As such, the illustrated embodiment shows a first battery pack 878a, a second battery pack 878b, and a third battery pack 878c electrically connected to the charger interfaces 824. In particular, the first battery pack 878a and the second battery pack 878b are disposed opposite each other and at the first side 856 of the charger 800. The third battery pack 878c is disposed at the second side 860 of the charger 800. Other charger interfaces 824 are not connected to a battery pack, and therefore corresponding shutters 864 are disposed in the actuated position.

The first battery pack 878a has a first charging level L1 that is below the charging threshold value. As such, corresponding shutters 864 remain in the unactuated position to define an airflow path between the first battery pack 878a and the housing 804 of the charger 800. The second battery pack 878b has a second charging level L2 that has reached or exceeded the charging threshold value. When the microcontroller 845 receives a signal indicating that the second battery pack 878b has reached or exceeded the charging threshold value, the actuator 890 is deactivated so that the corresponding shutters 864 can be biased towards the actuated position. The third battery pack 878c has a third charging level L3 similar to the first charging level L1 of the first battery pack 878a. As such, another airflow path is defined between the third battery pack 878c and the housing 804 of the charger 800.

The fans 854a, 854b are configured to generate a first airflow 858a and a second airflow 858b. The first airflow 858a is configured to flow through the first battery pack 878a via vents defined in the housing 880 of the first battery pack 878a. After that, the first airflow 858a is directed into the housing 804 of the charger 800 via inlet vents defined at a corresponding charger interface 824. The first airflow 858a is split into two separate air flow portions 858a1, 858a2 to be exhausted from outlet vents defined at the first and second sides 856, 860 of the charger 800. The second airflow 858b is similar to the first airflow 858a as discussed above. However, the second airflow 858b is configured to flow through the third battery pack 878c.

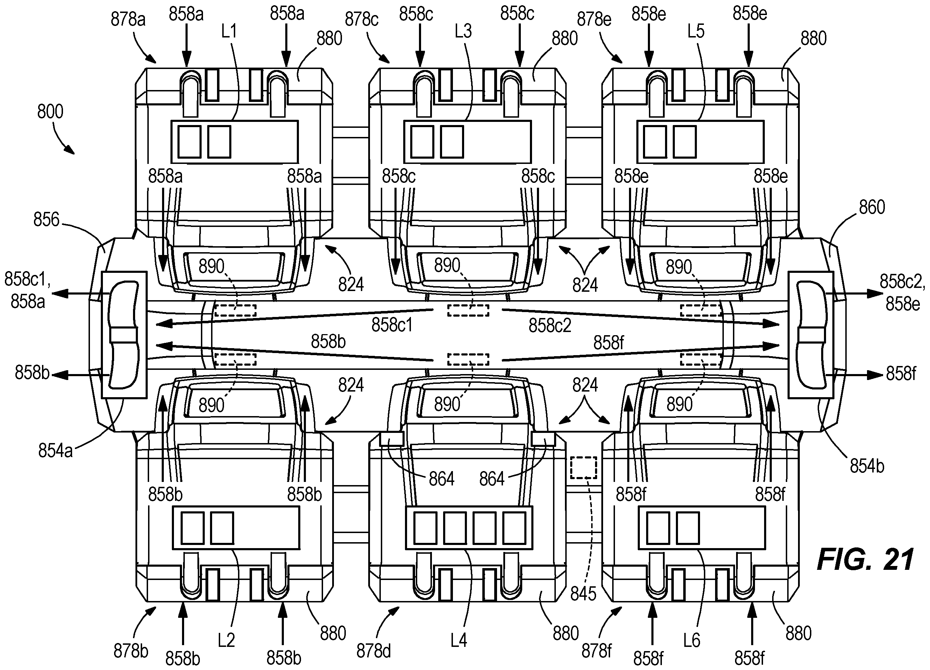

FIG. 21 illustrates an alternative embodiment of the battery packs 878 and the multi-battery pack charger 800 of FIG. 19. Each charger interface 824 of the charger 800 is electrically connected to a respective battery pack 878a-f. Multiple battery packs 878a-e have a charging level L1-5 that is below the charging threshold value. As such, corresponding shutters 864 remain in the unactuated position to define respective airflow paths between the battery packs 878a-e and the housing 804 of the charger 800. An individual battery pack 878f has a charging level L6 that has reached or exceeded the charging threshold value. As such, the microcontroller 845 receives a signal indicating the charging level L6 of the battery pack 878f. The microcontroller 845 deactivates the actuator 890 to allow corresponding shutters 864 to be biased toward the actuated position. The fans 854a, 854b are configured to generate multiple airflow paths 858a-e similar to the embodiment of FIG. 18 as discussed above.

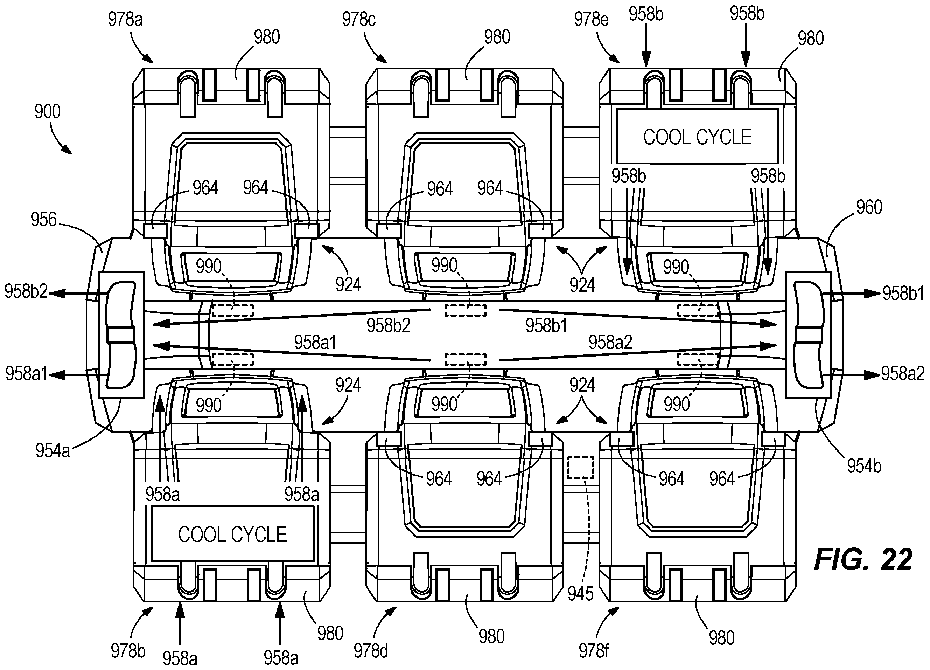

With reference to FIG. 22, another embodiment of battery packs 978 electrically connected to a multi-battery pack charger 900 is illustrated. The illustrated embodiment is similar to the embodiment of FIGS. 15 and 16; therefore, like structure will be identified by like reference number plus "400" and only the differences will be discussed hereafter.

In the illustrated embodiment, each charger interface 924 of the charger 900 is electrically connected to a respective battery pack 978a-f. The battery packs 978a-f are configured to be of a first battery type or of a second battery type. The first battery type corresponds to a cool-cycle battery pack, and the second battery type corresponds to a conventional battery pack. As such, the first and second battery packs 978a, 978b are cool-cycle battery packs. The first and second battery packs 978a, 978b each have a housing 980 and a battery cell frame (not shown) with vents to provide direct convective cooling over battery cells disposed within the battery packs 978a, 978b. The other battery packs 978c-f are conventional battery packs that are cooled by ambient cooling.

The charger 900 further includes an actuator 990 (e.g., a solenoid, a motor, or the like) for each charger interface 924. Each actuator 990 is configured to engage the shutters 964 of a corresponding charger interface 924. Initially, a biasing member is configured to bias the shutters 964 toward the actuated position when a respective charger interface 924 is not electrically connected to a battery pack. The shutters 964 are also configured to be biased toward the actuated position when the microcontroller 945 receives a signal indicating that the battery packs 978c-f are of the second battery type. In other embodiments, the actuators 990 may move the shutters 964 between the actuated position and the unactuated position.

In the illustrated embodiment, the first and second battery packs 978a, 978b each send a signal to the microcontroller 945 to indicate that the battery packs 978a-f have made an electrical connection with the charger interfaces 924. From the signal, the microcontroller is also able to determine that the first and second battery packs 978a, 978b are of the first battery type. The microcontroller 945 then operates the actuators 990 to move corresponding shutters 964 toward the unactuated position. As such, an airflow path is respectively defined between the first and second battery packs 978a, 978b and the housing 904 of the charger 900 to thereby allow airflow through the battery packs 978a, 978b to cool the battery circuitry and the battery cells. The battery packs 978a-f send additional signals to the microcontroller 945. The additional signals indicate a temperature and a charging level of the battery packs 978a-f. When the signal indicates that a respective battery pack 978a-f has a temperature that is below a temperature threshold value, then the microcontroller 945 operates a corresponding actuator 990 to move the shutters 964 toward the actuated position.

During a charging operation, the fans 954a, 954b generate a first airflow 958a and a second airflow 958b. The first airflow 958a is configured to flow through the first battery pack 978a via vents defined in the first battery pack 978a. The first airflow 958a is then directed into the housing 804 of the charger 900 via inlet vents defined at a corresponding charger interface 924. As the first airflow 958a flows through the charger 900, the first airflow 958a is split into two separate airflow portions 958a1, 958a2 to be exhausted from the outlet vents defined at the first and second sides 956, 960 of the charger 900. The second airflow 958b is similar to the first airflow 958a as discussed above. However, the second airflow 958b is configured to flow through the second battery pack 978b.

The charger 900 is configured to only provide a cooling operation at a charger interface 924 that is electrically connected to a battery pack of the first battery type. Since the first and second battery packs 978a, 978b are cool-cycle battery packs, the battery packs 978a, 978b are structured to have a greater cooling efficiency than the conventional battery packs 978c-f. As such, it is necessary to prevent airflow from flowing between the conventional battery packs 978c-f and the charger 900 to further improve the cooling efficiency of the cool-cycle battery packs 978a, 978b. The cool-cycle battery packs 978a, 978b may then be charged at a fast-charging rate since adequate cooling will only be provided to corresponding charger interfaces 924.

Although the disclosure has been described in detail with reference to certain preferred embodiments, variations and modifications exist within the scope and spirit of one or more independent aspects of the disclosure as described.

### REPRESENTATIVE FEATURES

Representative features are set out in the following clauses, which stand alone or may be combined, in any combination, with one or more features disclosed in the text and/or drawings of the specification.
1. A battery charger for charging a plurality of battery packs, the battery charger comprising:
   a housing;
   first and second charger interfaces formed on the housing, each charger interface configured to receive and charge a respective battery pack of the plurality of battery packs;
   first and second vents defined in the housing and respectively provided for the first and second charger interfaces, each vent configured to provide an airflow path defined through the respective battery pack and the housing; and
   a shutter provided for each charger interface, the shutter being movable between an actuated position, in which the shutter is oriented to at least partially block the airflow path, and an unactuated position, in which the shutter is out of the airflow path.
2. The battery charger of clause 1, wherein the first vent is one of a first plurality of vents and the second vent is one of a second plurality of vents.
3. The battery charger of clause 1, wherein the first and second vents are respectively in fluid communication with vents defined in the respective battery pack.
4. The battery charger of clause 1, wherein the shutter is biased toward the actuated position.
5. The battery charger of clause 1, wherein each shutter is configured to be moved to the unactuated position upon engagement of the respective charger interface by the respective battery pack.
6. The battery charger of clause 1, further comprising a fan disposed in the housing and configured to generate an airflow that flows along the airflow path.
7. A battery charger for charging a battery pack, the battery charger comprising:
   a housing;
   a charger interface formed on the housing, the charger interface configured to receive and charge the battery pack;
   a plurality of vents defined in the housing;
   at least one fan disposed in the housing, the fan configured to pull air into the housing through the plurality of vents; and
   a shutter disposed adjacent the plurality of vents, the shutter selectively at least partially blocking the plurality of vents.
8. The battery charger of clause 7, wherein the shutter is disposed within the housing.
9. The battery charger of clause 8, wherein the shutter includes at least one tab configured to extend outwardly from the housing for engagement by the battery pack.
10. The battery charger of clause 8, wherein the shutter includes a comb-like portion.
11. The battery charger of clause 7, wherein the plurality of vents is a first plurality of vents and the shutter is a first shutter, and wherein the battery charger further comprises a second plurality of vents and a second shutter selectively at least partially blocking the second plurality of vents.
12. The battery charger of clause 11, wherein the charger interface is disposed at least partially between the first plurality of vents and the second plurality of vents.
13. A battery charger for charging a battery pack, the battery charger comprising:
   a housing;
   a charger interface formed on the housing, the charger interface configured to receive and charge the battery pack;
   a plurality of vents defined in the housing and configured to provide an airflow path defined through the battery pack and the housing;
   a shutter disposed adjacent the plurality of vents, the shutter selectively at least partially blocking the airflow path;
   an actuator disposed within the housing and configured to move the shutter; and
   a controller disposed in the housing, the controller configured to
      determine that the battery pack has made an electrical connection with the charger interface, and
      operate the actuator to move the shutter at least partially out of the airflow path.
14. The battery charger of clause 13, wherein the controller is further configured to
   determine whether the battery pack is of a first type or of a second type, and
   operate the actuator to move the shutter to at least partially block the airflow path upon determining the battery pack is of the second type.
15. The battery charger of clause 13, wherein the controller is further configured to determine a charging level of the battery pack.
16. The battery charger of clause 15, wherein the controller is further configured to operate the actuator to move the shutter to at least partially block the airflow path upon determining the charging level has reached or exceeded a charging threshold value.
17. The battery charger of clause 13, wherein the shutter is biased toward at least partially blocking the airflow path.
18. The battery charger of clause 13, further comprising a fan disposed in the housing and configured to generate an airflow that flows along the airflow path.
19. The battery charger of clause 13, wherein the controller is further configured to
   determine a temperature of the battery pack, and
   operate the actuator to move the shutter to at least partially block the airflow path upon determining the temperature of the battery pack is below a temperature threshold value.
20. The battery charger of clause 13, wherein the battery pack is a power tool battery pack.

## Claims

1. A battery charger for charging a plurality of battery packs, the battery charger comprising:
a housing;
first and second charger interfaces formed on the housing, each charger interface configured to receive and charge a respective battery pack of the plurality of battery packs;
first and second vents defined in the housing and respectively provided for the first and second charger interfaces, each vent configured to provide an airflow path defined through the respective battery pack and the housing; and
a shutter provided for each charger interface, the shutter being movable between an actuated position, in which the shutter is oriented to at least partially block the airflow path, and an unactuated position, in which the shutter is out of the airflow path.

2. The battery charger of claim 1, wherein the first vent is one of a first plurality of vents and the second vent is one of a second plurality of vents.

3. The battery charger of claim 1 or claim 2, wherein the first and second vents are respectively in fluid communication with vents defined in the respective battery pack.

4. The battery charger of any preceding claim, wherein the shutter is biased toward the actuated position, and/or wherein each shutter is configured to be moved to the unactuated position upon engagement of the respective charger interface by the respective battery pack.

5. The battery charger of any preceding claim, further comprising a fan disposed in the housing and configured to generate an airflow that flows along the airflow path.

6. A battery charger for charging a battery pack, the battery charger comprising:
a housing;
a charger interface formed on the housing, the charger interface configured to receive and charge the battery pack;
a plurality of vents defined in the housing;
at least one fan disposed in the housing, the fan configured to pull air into the housing through the plurality of vents; and
a shutter disposed adjacent the plurality of vents, the shutter selectively at least partially blocking the plurality of vents.

7. The battery charger of claim 6, wherein the shutter is disposed within the housing.

8. The battery charger of claim 6 or claim 7, wherein the shutter includes at least one tab configured to extend outwardly from the housing for engagement by the battery pack, and/or wherein the shutter includes a comb-like portion.

9. The battery charger of any one of claims 6 to 8, wherein the plurality of vents is a first plurality of vents and the shutter is a first shutter, and wherein the battery charger further comprises a second plurality of vents and a second shutter selectively at least partially blocking the second plurality of vents, preferably wherein the charger interface is disposed at least partially between the first plurality of vents and the second plurality of vents.

10. A battery charger for charging a battery pack, the battery charger comprising:
a housing;
a charger interface formed on the housing, the charger interface configured to receive and charge the battery pack;
a plurality of vents defined in the housing and configured to provide an airflow path defined through the battery pack and the housing;
a shutter disposed adjacent the plurality of vents, the shutter selectively at least partially blocking the airflow path;
an actuator disposed within the housing and configured to move the shutter; and
a controller disposed in the housing, the controller configured to
determine that the battery pack has made an electrical connection with the charger interface, and
operate the actuator to move the shutter at least partially out of the airflow path.

11. The battery charger of claim 10, wherein the controller is further configured to
determine whether the battery pack is of a first type or of a second type, and
operate the actuator to move the shutter to at least partially block the airflow path upon determining the battery pack is of the second type, and/or
wherein the controller is further configured to determine a charging level of the battery pack.

12. The battery charger of claim 11, wherein the controller is further configured to operate the actuator to move the shutter to at least partially block the airflow path upon determining the charging level has reached or exceeded a charging threshold value.

13. The battery charger of any one of claims 10 to 12, wherein the shutter is biased toward at least partially blocking the airflow path.

14. The battery charger of any one of claims 10 to 13, further comprising a fan disposed in the housing and configured to generate an airflow that flows along the airflow path.

15. The battery charger of any one of claims 10 to 14, wherein the controller is further configured to
determine a temperature of the battery pack, and
operate the actuator to move the shutter to at least partially block the airflow path upon determining the temperature of the battery pack is below a temperature threshold value, and/or
wherein the battery pack is a power tool battery pack.
